Europäisches Patentamt

European Patent Office

Office européen des brevets

(11) Publication number: **0 449 022 A2**

# EUROPEAN PATENT APPLICATION

(21) Application number: 91103687.9

(51) Int. Cl.5: **G03F 7/16**

(22) Date of filing: **11.03.91**

(30) Priority: **26.03.90 US 498618**

(43) Date of publication of application:
**02.10.91 Bulletin 91/40**

(84) Designated Contracting States:
**DE FR GB IT**

(71) Applicant: **SHIPLEY COMPANY INC.**
**2300 Washington Street**
**Newton, Massachusetts 02162(US)**

(72) Inventor: **Hawkins, Robert E.**
**21 Oak Drive**
**Upton, Massachusetts 01568(US)**
Inventor: **Rodriguez, Stephen S.**
**11 Friendship Lane Monument Beach**
**Massachusetts 02553(US)**

(74) Representative: **Leiser, Gottfried, Dipl.-Ing. et al**
**Patentanwälte Prinz, Leiser, Bunke & Partner**
**Manzingerweg 7**
**W-8000 München 60(DE)**

(54) Method of controlling photoresist film thickness and stability of an electrodeposition bath.

(57) It has been discovered that both water soluble or partially water soluble and water insoluble agents lower the operating temperature of electrodepositable photoresist compositions and substantially increase both lifetime stability and temperature stability of the bath.

These additives, because of their low volatility and their partition coefficients, essentially remain in the emulsion system and are removed upon codeposition with the photoresist where they act to improve film quality and control thickness.

## BACKGROUND OF THE INVENTION

### 1. Introduction

The present invention relates to a photosensitive polymer composition and its use in an electrodeposition process for applying an adherent, uniform photosensitive film of desired thickness on a conductive surface.

More particularly, the invention relates to an improved photosensitive polymer composition, formed from an aqueous emulsion or solution of at least one polymer having charged carrier groups, a photoinitiator and a source of unsaturation for cross-linking the deposited film upon exposure to actinic radiation, further comprising addition to said polymer composition, a coalescent agent which decreases the operating temperature of the composition and increases its stability over both time and temperature.

The improved polymer composition of the present invention is capable of being electrodeposited on a conductive surface as a uniform, aqueous developable film of desired thickness that is resistant to strong inorganic acids and aqueous bases.

### 2. Discussion of the Prior Art

Photoresists are photosensitive films capable of transferring an image onto a conductive surface such as, for example, the metal surface of a printed circuit board or lithographic plate. Liquid type photoresists typically contain a combination of a film forming resin or polymer and a photosensitive compound or photoinitiator dissolved or suspended in a solvent such as an organic liquid.

Liquid type photoresists can be negative-acting or positive-acting systems. In the case of a negative-acting photoresist or negative resist, after the film is deposited on a surface and the solvent is removed as by heating, the film is selectively exposed, typically through a photomask, to a source of energy, such as ultraviolet light. The photomask has areas that are opaque and other areas that are transparent to the exposing radiation. The pattern on the photomask formed by the opaque and transparent areas defines the desired image, such as, for example, a circuit, which is to be transferred to the substrate surface. The exposed portions of a negative resist film become less soluble in a developing solution than the unexposed portions, as the result of a photochemical reaction between the photoinitiator and the polymer or resin upon exposure. This difference in solubility allows for the selective removal of unexposed film and the transfer of the image to the surface.

In a positive resist, the exposed portions of the film become more soluble in the developer than the unexposed portions, as a result of the photochemical reaction, allowing for the selective removal of the exposed areas. After either type of resist film is developed, the portions of the surface that are not protected by the resist may be etched, such as by the action of an oxidizing solution typically containing an inorganic acid. The remaining resist film may then be stripped from the surface leaving only the desired etched image on the substrate. Alternatively, the substrate surface containing the imaged resist can be plated with a metal or combination of metals, such as, for example tin and lead. The resist may then be selectively stripped and the exposed metal on the substrate may be etched to form the desired pattern or a circuit on the substrate surface. The historical background, types and operations of conventional photoresists is described in Photoresist Materials and Processes, W. S. DeForest, McGraw-Hill, 1975.

Although liquid type resists have been used for many years in lithographic and electronic applications, and despite numerous improvements to the resist systems and processing steps involved with their use, these conventional liquid resists still suffer from one or more disadvantages. For example, special surface preparations may be required to obtain good adhesion of a liquid resist film onto a surface. This increases the processing time and cost involved. The resists themselves may also require other special processing steps, such as hardening or baking steps, which also increase processing time. The cost of the resist components utilized in conventional systems combined with the loss of materials in depositing a film and the difficulty in reproducibly synthesizing stable systems, has also been a problem.

The most widely recognized drawback of liquid resists, however, has been the difficulty to deposit films of uniform and adequate thickness on surfaces without the formation of voids or pinholes. Furthermore, there remains a need for a resist having resistance to etching and electroplating baths that are functional over a wide range of exposing radiations at minimal exposure doses and times.

As described above, the composition of the present invention is especially suited for electrodeposition. Electrodeposition is conducted in an electrolytic cell where the surface of the conductive material, to be coated by the migrating charged particles, serves as one electrode. Polymers bearing a positive charge in the liquid medium are known as cationic polymers. The electrodeposition of cationic polymers on the surface of a negatively charged electrode (cathode) is referred to as cataphoresis, while the electrodeposition of negatively charged polymers (anionic polymers) onto the surface of a positively charged electrode (anode) is known as anaphoresis.

Coating metal objects with organic materials by electrodeposition is well known and is widely used to paint metal surfaces such as automobiles. Electrodeposition has been used to prepare electrical components, such as resistors and capacitors, that are integral to printed circuit boards (U.S. Patent No. 3,303,078).

Electrodeposition of photosensitive coatings is also well known. U.S. Patent No. 3,738,835 describes the deposit of a photosensitive composition from an emulsion prepared from a solution containing a polychloroprene polymer, a photosensitizer, such as 4,4'-bis-(dimethyl-amino)benzophenone, a stabilizer, such as hydroquinone that prevents the unsaturated polymer from decomposing in solution, and a hardener such as a partially cured resin or other polymer to provide etch resistance, in an 80% butyl acetate 20% methyl ethyl ketone or 80% cyclohexanone 20% methyl ethyl ketone solvent. The emulsion is formed by the addition of an aqueous solution containing a wetting agent, such as fluorocarbon anionic surfactant, N-methyl-2-pyrolidone and triethylamine to the first solution. Upon exposure of the photosensitive composition to radiation, the unsaturated polymer cross-links and the unexposed film is developed with an organic solvent.

Japanese Patent Application No. 77-11601 describes a method for electrodepositing a photosensitive polymer composition onto a silicate coated metal surface. The photosensitive polymers are soluble or dispersible in an aqueous medium and capable of being anaphoretically deposited on a conductive surface by virtue of containing a neutralized acid group. The polymers are photosensitive by virtue of containing unsaturated groups that cross-link upon exposure to light.

Japanese Patent Disclosure No. 55(1989)-14891 entitled Method for Preparing Printed Wiring Boards discloses using electrodeposition for coating photosensitive substances onto the copper surface of a copper laminated plate in preparing printed circuit boards, however, this reference does not describe any materials useful for the process or any of the process conditions used therein.

U.S. Patent No. 4,592,816 describes a photosensitive polymer composition capable of being electrodeposited as a uniform photosensitive film on a conductive surface. The thickness of the film deposited is controlled by both temperature and electrodeposition potential applied. In order to obtain thin coatings, it is necessary to operate the bath at higher temperatures or lower applied potential. Thicker coatings are obtained by using a higher applied potential. Both of these procedures for controlling thickness have deleterious effects on the bath and the quality of the film deposited. The components of the bath are not stable at high temperatures over an extended period of time; also, higher temperatures result in hard, brittle, usually crazed coatings with reduced sensitivity. Use of higher potentials will negatively affect the quality of the deposited film due to generation of bubbles which adhere to the surface and produce pinhole defects.

U.S. Patent 4,810,738 discloses an additive composition for achieving thicker films by electrophoretic deposition techniques. The composition is multicomponent and contains surfactants, viscosity modifiers and another immisicible solvent. These components must be mixed in precise amounts relative to each other in order to obtain the desire thicknesses. The additive composition is not used to lower the operating temperature of the bath and does not produce pin-hole free coatings at the thickness deposited.

## SUMMARY OF THE INVENTION

The photosensitive formulation baths previously used for electrodeposition of photoresist coatings were not stable if operated at the high temperatures needed for depositing the thin coatings required for use as print and etch resists. Bath life is no more than one week and the coatings obtained using these prior art chemistries yield coatings which are badly pinholed.

It has been found that by incorporating certain components in the bath, the desired thick or thin films may be obtained at lower operating temperatures and the additives also contribute to the stability of the bath. The thus obtained films are both uniform and pinhole free.

It has further been discovered that both water soluble or partially water soluble and water insoluble agents lower the operating temperature of the electrodepositable photoresist composition and substantially increase bath stability.

These additives, because of their low volatility and their partition coefficients, essentially remain in the emulsion system and are removed upon codeposition with the photoresist where they act to improve film quality and control the thickness of the deposited film. The additive chosen and the amount present in the bath allows for control of the thickness of the film deposited and the temperature at which the desired thickness may be obtained. Upon storing or even standing, the coated film's ability to coalesce and level are greatly enhanced. Thus, small imperfections that would otherwise be present are effectively eliminated.

In contrast to the improved films prepared by the method of the present invention, the thick coatings obtained using prior art electrodeposited photoresist systems are badly pinholed. Using the additives of the present invention in an electrodeposited photoresist system allows for coatings of up to twice the normal thickness at lower operating temperatures. Such coatings are pinhole free and suitable for use as a plating resist.

## DESCRIPTION OF THE PREFERRED EMBODIMENTS

Suitable electrodepositable coating compositions capable of use in the present invention are those disclosed in U.S. Patent No. 4,592,816 and U.S. Patent No. 4,632,900, which are incorporated herein by reference. These compositions comprise aqueous solutions or emulsions of at least one polymer containing a carrier group, optionally a photoinitiator and a source of unsaturation for a cross-linking reaction if the composition is to be used as a photoresist. The source of unsaturation is preferably a monomer.

The polymer component of the composition contains carrier groups that become positively or negatively charged upon contact with either an acid or a base, dependent upon the specific carrier group employed. The carrier group is one selected so that a deposited film will be developable with an aqueous acid or aqueous base solution. Suitable polymers are addition and condensation polymers having the aforesaid carrier groups. Addition polymers having carrier groups prepared from monomers having ethylenic unsaturation are preferred. Polymers containing carrier groups that are useful in the photosensitive polymer composition include acrylic polymers, vinyl polymers other than acrylic polymers, epoxy polymers, polyurethanes, polyesters and polyamides.

Polymers having positively charged carrier groups i.e., cataphoretic carrier groups, will deposit on a negatively charged electrode. Such carrier groups include, for example, quaternary ammonium groups and phosphonium groups which become positively charged upon reaction with an acid. The acids that are useful to protonate the carrier groups of the polymers include lactic acid, glycolic acid, hydroxyacetic acid, hydrochloric acid, formic acid, acetic acid and phosphoric acid.

Polymers having negatively charged carrier groups i.e., anaphoretic carrier groups, will deposit on a positively charged electrode. Carboxylic acid groups are suitable negatively charged carrier groups.

For photoactive coatings, the preferred compositions suitable for electrodeposition are formed by mixing the polymer containing carrier groups with at least one unsaturated monomer and a photoinitiator so that a polymer film electro deposited on a surface is capable of being polymerized into a cross linked polymer when exposed to actinic radiation. Unsaturated monomers having two or more unsaturated groups attached to the same molecule are preferred. Most preferred are the multifunctional monomers having two or more acrylates or methacrylate groups attached to each monomer molecule. Examples of suitable monomers are set forth in the above referenced patent. Examples of photoinitiators suitable for use in the polymeric composition include the azo compounds, sulfur-containing compounds, metallic salts and complexes, oxines, amines, polynuclear compounds, organic carbonyl compounds, various quinones, etc. Specific examples of suitable photoinitiators are also set forth in U.S. Patent No. 4,592,816.

A preferred electrodepositable composition for purposes of the invention expressed as the relative concentrations of polymer, photoinitiator, unsaturated monomer and acid are given in the following table (weight based on 100 parts by weight of polymer):

## TABLE I

| Ingredient | Relative Concentration |
|---|---|
| Polymer | 100 |
| Solvent | 0 - 70 |
| Unsaturated Monomer | 30 - 50 |
| Photoinitiator | 3 - 8 |
| Acid | 1 - 3 |
| Water | 900 - 2600 |

As would be obvious to those skilled in the art, the compositions may also contain other additives such as coloring matter, plasticizers, wetting agents and the like customarily used in an electrodeposition bath. These additional components have been used to promote adhesion to the substrate but do not control the thickness of the deposit.

In order to promote uniform application of the photoresist to the substrate at the desired thickness, a coalescent agent is added to the photosensitive polymeric composition. The coalescent agent partitions into the photoresist micelles and is codeposited with the photoresist micelles, allowing the film to better form during deposition and subsequent baking. The coalescent agent also softens the micelles resulting in a coating which, unlike prior art coatings, is thin but not hard.

Preferred coalescent agents include both water soluble or partially water soluble and water insoluble agents. Of the water soluble or partially water soluble agents, the preferred agents include 1-nitropropane, 2-nitropropane, M-Pyrol (methyl pyrrolidone), ethylene glycol ethylhexylether, propylene glycol methylether, high molecular weight polypropylene glycols and Texanol (2,2,4-trimethyl 1,3 pentanediol monoisobutyrate from Eastman Kodak). Other coalescent agents include copolymers of ethyl acrylate such as Modaflow (Monsanto); surfactants such as oleyl alcohol, Flexrecin (polyol ricinoleates from CasChem) , FC 430 (fluorocarbon surfactant from 3M), and Foam kill 639AA (defoamer). Lubricants useful as coalescent agents include oleoamide and high molecular weight polymers such as Lubrizol 5907. Waxes may also be used such as EM-11 and EM-937(from Axel Manufacturing). The most preferred coalescent agent is ethylene glycol ethylhexylether.

The partition coefficient of the coalescent agent determines how much is codeposited with the film. The amount of the coalescent agent employed may vary depending on a number of factors including the partition coefficient of the selected agent between the organic micelles and aqueous phase. The coalescent agent is normally added to the bath prior to emulsification (i.e., prior to addition of water in the above Table I). A good discussion of such factors is described in T.N. Visser, in Selecting Solvents for Electrodeposit Paints, FATIPEC, 18th (Vol. 1-B) at pages 367-394 (1986).

In general, for water soluble or partially water-soluble coalescent agents, the amount may be up to about 25% by weight of the emulsion (including both solids and the aqueous portion), preferably between about 10-20% by weight, and most preferably between about 14-18% by weight. For water insoluble coalescent agents, the amount may be up to about 15% by weight of solids used to form the emulsion, preferably between about 2-10% by weight, and most preferably between about 4-6% by weight.

The present invention will be further illustrated with reference to the following examples which aid in the understanding of the present invention, but which are not to be construed as limitations thereof. All percentages reported herein, unless otherwise specified, are percent by weight. All temperatures are expressed in degrees Celsius.

## EXAMPLE 1

### Electrodeposition Composition

```
Polymer                                                        91.0 g
      Dimethylaminoethyl methacrylate -  8 parts
      Methyl methacrylate - 75 parts
      Ethyl acrylate - 17 parts

Monomer                                                        46.0 g
      Dipentaerythritol monohydroxy penta-acrylate

Dye                                                             1.1 g
      Morton ERO Blue from Morton Thiokol

Coalescent Agent                                              160.0 g
      Propylene glycol methylether

Photoinitiators                                                11.0 g
      2-methyl-1-[4-(methylthio)phenyl]-
          2-morpholino-propan-1-one - 8.3 g
      Isopropylthioxanthone - 2.7 g

Acid                                                           15.0 g
      Lactic Acid 20%

Distilled Water to make up 1000 g

Bath temperature: 20°C  Voltage: 50 volts   Time: 10 sec.
```

Typically, a portion of the above composition is added to a 250ml beaker used as a plating cell. A 1" x 2" stainless steel plate is used as the anode and the circuit board base material is used as a cathode. The anode to cathode space was 2 inches. The coating is applied under conditions described in the above table. Thickness measurements are then made to determine the applied coating thickness. Measurements may be made using methods well known in the art which include use of a beta backscatter instrument such as "Microderm" manufactured by UPA Technology, or a profilometer such as "Dektak" manufactured by The Sloan Technology Company. The thickness of the coating obtained under the above conditions was 5 microns.

EXAMPLE 2

The following table shows a comparison of thickness to temperature profiles for the photoresist formulation of Example 1 where the preferred coalescent agent is ethylene glycol ethylhexylether (EEH). Conditions for depositing the resist were the same as Example 1. The data shown represents thickness determination of coating depositions when the bath composition is with and without the added coalescent agent, EEH:

**TABLE II**

| Temperature °C | Thickness with EEH (microns) | Thickness without EEH |
|---|---|---|
| 5 | 24 | 58 |
| 10 | 16 | 57 |
| 15 | 11 | 36 |
| 20 | 8 | 23 |
| 25 | 10 | 16 |
| 30 | 12 | 10 |
| 35 | 14 | 8 |
| 40 | 19 | 8 |

The above table illustrates that the desired thin coatings used as print and etch resists (usually < 10 microns) can be obtained at a temperature 15 degrees lower than without the added coalescent agent. Also, at the higher end of the temperature scale where it would be expected that thinner coating would be deposited, thicker coatings suitable for use as plating resists (usually > 10 microns) may be obtained with the added coalescent agent. These thicker coatings do not display pinhole defects as found in prior art coatings of comparable thicknesses or those deposited at lower temperatures.

EXAMPLE 3

The amount of coalescent agent present in the bath also determines the thickness of the coatings at various temperatures. This is illustrated by the following table which shows temperature to thickness profiles for varying amounts of propylene glycol methyl ether added to the photoresist formulation given in Example 1:

**TABLE III**

| Temperature °C | Percent Propylene Glycol Methyl Ether | | | | | | |
|---|---|---|---|---|---|---|---|
| | 2 | 4 | 6 | 8 | 10 | 12 | 14 |
| 30 | >28 | >28 | >28 | 22 | 21 | 18 | 15 |
| 35 | 25 | 20 | 18 | 12 | 10 | 10 | 8 |
| 40 | 14 | 11 | 10 | 7 | 6 | 5 | 4 |
| 45 | 8 | 6 | 6 | 4 | 4 | 4 | 4 |

(Thickness in microns)

Voltage: 50 volts          Time: 10 sec

By choosing the correct temperature and amount of coalescent agent, it is possible to control the thickness of the coating and obtain both thin and thick coatings at temperatures lower than required by conventional bath compositions.

## EXAMPLE 4

### Electrodeposition Composition

| | |
|---|---|
| Dimethylaminoethylmethacrylate, ethylmethacrylate methyl-methacrylate copolymer | 43.7 g |
| Dipentaerythritol monohydroxy penta-acrylate | 13.2 g |
| 2-Isopropylthioxanthone | 0.6 g |
| 2-methyl-1[4-(methylthio)phenyl]-2-morpholino-propan-1-one | 2.1 g |
| 9-10 anthracenedione,1,4-bis(alkyl amino) | 0.3 g |
| 20% lactic acid in water | 2.6 g |

Duplicate portions of this bath were made and 8 grams of the coalescent agents 1-nitropropane and 2-nitropropane were added to the separate portions. The baths were operated at room temperature (25° C) and 50 volts for 10 seconds. The coatings deposited in both cases were 5 microns thick with a photospeed of 100 millijoules, showing no adverse affect on photospeed.

The present invention has been described in detail, including the preferred embodiments thereof. However, it will be appreciated that those skilled in the art, upon consideration of the present disclosure, may make modifications and/or improvements on this invention and still be within the scope and spirit of this invention as set forth in the following claims.

## Claims

1. A method of controlling the thickness of an electrodeposited photoresists which comprises adding to said photoresist formulation a coalescent agent which codeposits with said photoresists and forms a uniform film of desired thickness.

2. The method of claim 1 wherein said photoresist formulation contains a solvent, polymer, unsaturated monomer, photoinitiator, electrolyte and water.

3. The method of claim 1 wherein said coalescent agent is selected from the group comprising 1-nitropropane, 2-nitropropane, methyl pyrrolidone, ethylene glycol ethylhexylether, propylene glycol methylether, 2,2,4-trimethyl-1,3 pentanediol monoisobutyrate, high molecular weight polypropylene glycols, copolymers of ethyl acrylate, oleyl alcohol, polyol ricinoleates, high molecular weight fluorocarbon surfactants, defoaming agents, oleoamide and waxes.

4. The method of claim 1 wherein said coalescent agent is ethylene glycol ethylhexylether.

5. The method of claim 1 wherein said photoresist is applied cataphoretically.

6. The method of claim 1 wherein said photoresist is applied anaphoretically.

7. The method of claim 1 wherein said coalescent agent is added in an amount up to 25% by weight of the emulsion.

8. The method of claim 1 wherein said coalescent agent is selected based on an organic/aqueous partition coefficient of 50/50.

9. The method of claim 1 wherein said uniform film of desired thickness is in the range of 1 - 50 microns.

10. A method of controlling the operating temperature of an electrodeposited photoresist bath comprising adding to said photoresist bath a coalescent agent to lower the operating temperature of said bath.

11. The method of claim 10 wherein said operating temperature is in the range of 5 - 40° C.

12. The method of claim 10 wherein said photoresist formulation contains a polymer, solvent, unsaturated monomer, photoinitiator, electrolyte and water.

13. The method of claim 10 wherein said coalescent agent is selected from the group comprising 1-nitropropane, 2-nitropropane, methyl pyrrolidone, ethylene glycol ethylhexylether, propylene glycol methylether, 2,2,4-trimethyl-1,3 pentanediol monoisobutyrate, high molecular weight polypropylene glycols, copolymers of ethyl acrylate, oleyl alcohol, polyol ricinoleates, high molecular weight fluorocarbon surfactants, defoaming agents, oleoamide and waxes.

14. The method of claim 10 wherein said coalescent agent is ethylene glycol ethylhexylether.

15. The method of claim 10 wherein said photoresist is applied cataphoretically.

16. The method of claim 10 wherein said photoresist is applied anaphoretically.

17. The method of claim 10 wherein said coalescent agent is added in an amount up to 25% by weight of the emulsion.

18. The method of claim 10 wherein said coalescent agent is selected based on an organic/aqueous partition coefficient of